Europäisches Patentamt

European Patent Office

Office européen des brevets

(19)

(11)  EP 1 628 349 A2

(12)  **EUROPEAN PATENT APPLICATION**

(43) Date of publication:
    **22.02.2006 Bulletin 2006/08**

(51) Int Cl.:
    *H01L 29/94* (2006.01)    *H01L 21/329* (2006.01)
    *H01L 27/08* (2006.01)

(21) Application number: **04258038.1**

(22) Date of filing: **22.12.2004**

(84) Designated Contracting States:
    **AT BE BG CH CY CZ DE DK EE ES FI FR GB GR
    HU IE IS IT LI LT LU MC NL PL PT RO SE SI SK TR**
    Designated Extension States:
    **AL BA HR LV MK YU**

(30) Priority: **19.08.2004 JP 2004238975**

(71) Applicant: **FUJITSU LIMITED
    Kawasaki-shi,
    Kanagawa 211-8588 (JP)**

(72) Inventors:
    • **Kakimura, Yasushi,
      c/o Fujitsu Limited
      Kawasaki-shi,
      Kanagawa 211-8588 (JP)**
    • **Muraya, Keisuke
      c/o Fujitsu Limited
      Kawasaki-shi,
      Kanagawa 211-8588 (JP)**

(74) Representative: **Stebbing, Timothy Charles et al
    Haseltine Lake,
    Imperial House,
    15-19 Kingsway
    London WC2B 6UD (GB)**

(54)    **Mis capacitor and production method of mis capacitor**

(57)     A silicon wafer (8), with a diffusion area (7) formed in a predetermined region on one side, comprises a lower electrode of a capacitor unit (10). A first metal layer (2) is connected to a first power supply wiring (VDD) and comprises an upper electrode of the capacitor unit (10). Second metal layers (6a, 6b) are connected to a second power supply wiring (GND) and are also formed on the side where diffusion area (7) is formed on silicon wafer (8). An oxide film (3) is placed between the first metal layer (2) and the surface of the silicon wafer (8) where the diffusion area (7) is formed. The capacitance of the capacitor unit (10) is determined by the dielectric constant ε and thickness T of the oxide film (3).

F I G. 3

**Description**

The present invention relates to an MIS (Metal-Insulator-Silicon) capacitor and a production method of an MIS capacitor.

It is known to use a plurality of logic cells in integrated circuits. For example, Japanese Published Unexamined Application bulletin No. 6-21263 discloses a plurality of logic cells for loading integrated circuits, the logic cells being connected to power supply wiring VDD and power supply wiring GND and being installed on integrated circuits. The area between logic cells is, according to logic connection information, a forming area of metal wiring for connection.

However, crosstalk noise between wirings and simultaneous-switching noise of transistors constantly cause voltage variation in the voltage of power supply wiring on the integrated circuit. This voltage variation causes a slowdown in operation speed of transistors, mechanical errors, and so on. Given this fact, in order to control the voltage variation, a technique of installing a decoupling capacitor in the metal area between power supply wirings is disclosed in Japanese Published Unexamined Application bulletin No.2001-185624. According to this technique, temporary voltage variation caused by noise etc. can be controlled by electric charges stored in the capacitor.

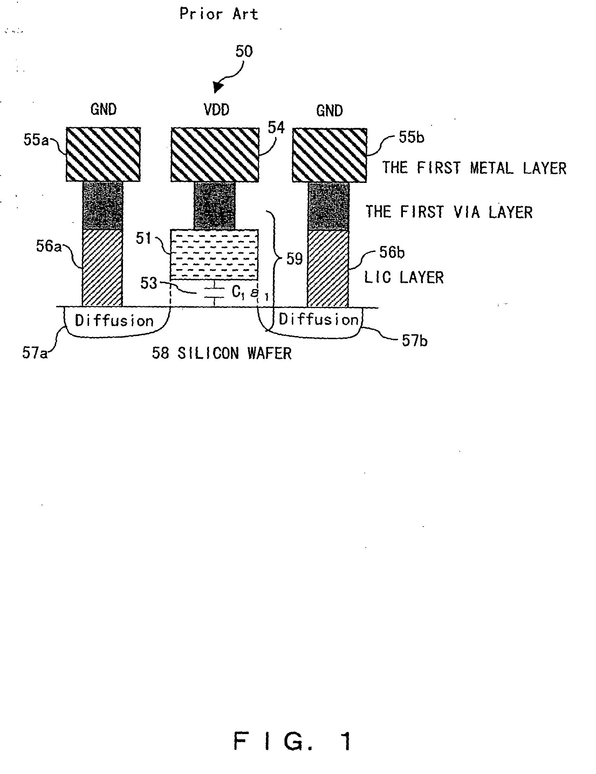

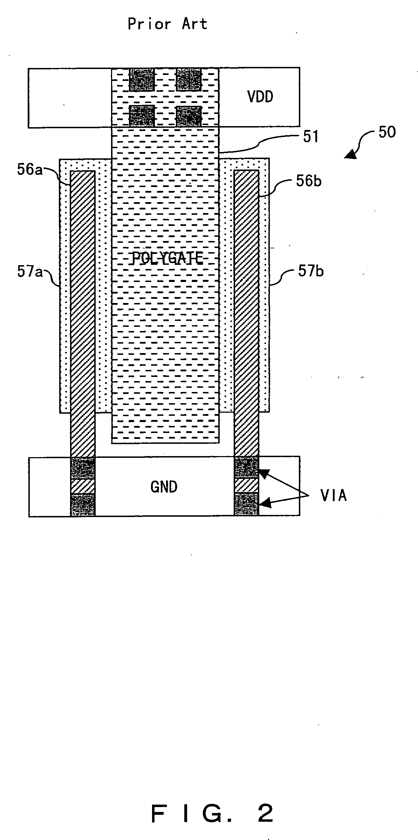

For the purpose as described above, for the capacitors used on integrated circuits, in the conventional manner, a transistor component itself was used as a capacitor by utilizing the thin and high dielectric constant material, or the gate oxide of the transistor, for example. For those conventional capacitors used on integrated circuits, a capacitor cell made up of the conventional capacitor, which has a gate unit and its underlying base plate as electrodes, is arranged in the forming area of the metal wiring. Fig. 1 is a cross-sectional diagram of the capacitor of the related art, and Fig. 2 is a type of configuration of the capacitor of the related art.

On the silicon wafer 58, polygate 51 and LIC (Local Interconnect) 56a and 56b, which are composed of materials such as tungsten, are arranged through gate oxide film 53 composed of dielectrics with dielectric constant ε1. LIC 56a and 56b are formed directly on the silicon wafer 58. Polygate 51 is connected to the gate of the transistor and LIC 56a and 56b are respectively connected to either the source or the drain. Diffusion areas 57a and 57b are formed in the contact points of LIC 56a and 56b on the silicon wafer 58.

The capacitor described in Fig.1 and Fig.2 has polygate 51 and its underlying silicon wafer 58 as electrodes, is composed of gate oxide film 53 with dielectric constant ε1, and, by capacitor unit 59, ensures necessary capacitance C1 of the capacitor to control the voltage variation.

The capacitor 50 utilizing the gate oxide film of the transistor as described in Fig.1 and Fig.2 has a problem in that as the area of the polygate 51 used as an electrode is increased in order to increase the capacitance C1 of capacitor unit 59, the resistance of the polygate 51 on the electrode also increases, and the capacitance C1 of capacitor unit 59 which is effective against high frequency noise is reduced.

In addition, the gate oxide film of transistors is getting thinner as a result of the high-integration and high-density technology used in integrated circuits in recent years. As the gate oxide film gets thinner, capacitance C1 of the capacitor increases, and leakage current also increases. This causes problems such as increase in the power consumption of the chip itself, which includes the capacitor, and a transistor that cannot serve as a capacitor.

It is therefore desirable to provide a capacitor that reduces power consumption and that retains the same capacitance as that of conventional capacitors, and which has a reduced leakage current.

An MIS capacitor (transistor) according to the present invention comprises: a silicon wafer provided with a diffusion area formed in a predetermined region on one side and that comprises a lower electrode of a capacitor unit; a first metal layer that is connected to a first power supply wiring and that comprises an upper electrode of the capacitor unit; a second metal layer connected to a second power supply wiring and formed on the surface of the diffusion area of the silicon wafer; and an oxide film placed between the first metal layer and the surface of the diffusion area on the silicon wafer.

The upper electrode of the capacitor is composed of the first metal layer. For this reason, the sheet resistance of the electrode units of the capacitor can be decreased. The oxide film placed between the first metal layer, which comprises the upper electrode, and the silicon wafer is made into the desired thickness. Therefore, it is possible for the present MIS capacitor to retain the same capacitance as the conventional capacitor without changing the space for (size of) the device.

The first metal layer can be connected to the first power supply wiring through a first wiring metal (metallisation) which is electrically conductive, and the second metal layer can be connected to the second power supply wiring through a second wiring metal, which is also electrically conductive. In addition, the first power supply wiring can be connected to a gate of the transistor, which forms the capacitor, and the second power supply wiring can be connected to either a source or a drain of the transistor.

The first and second metal layers may comprise local interconnect. Tungsten for example, is preferred. Also, field oxide film is preferred for the oxide film.

An MIS capacitor production method according to the present invention, comprises: forming a diffusion area on a predetermined region of a silicon wafer; forming an insulator layer on the silicon wafer; making a first hole, a second hole, and a third hole in the insulator layer, each of the holes reaching the diffusion area on the silicon wafer through the insulator layer; forming an oxide film with a predetermined thickness at the bottom of the first hole; and filling the first hole, the second hole, and the third hole with metal.

According to the present invention, because the upper electrode of the capacitor is composed of metal, the sheet resistance of the capacitor electrode unit can be lowered. As a result, an increase of capacitance in the high frequency area becomes possible. Because a dielectric is used as the oxide film and the thickness of the oxide film can be established/set freely, capacitance of the MIS capacitor can be flexibly set. And using oxide film material with a higher dielectric constant allows the capacitor to maintain a large capacitance, reduces leakage current in the capacitor and controls the power consumption. Also, because there is no need to change the area of the upper electrode of the MIS capacitor, more effective control of high frequency noise is possible without changing the area of the silicon wafer, hence chip, occupied by the capacitor.

Reference is now made, by way of example only, to the accompanying drawings, in which:

Fig. 1 is a cross-sectional diagram of a conventional capacitor;
Fig. 2 exemplifies a configuration of the conventional capacitor;
Fig. 3 shows a cross-sectional diagram of an example of an MIS capacitor according to an embodiment of the invention;
Fig. 4 is an overhead view of the MIS capacitor of Fig. 3;
Fig. 5 explains a production process of an MIS capacitor according to the embodiment;
Fig. 6 is a cross-sectional diagram of another example of an MIS capacitor according to the embodiment;
Fig. 7 explains the characteristics of a capacitor based on the structure of an MIS capacitor of the embodiment;
Fig. 8 is a graph schematically showing the relationship between the absolute value of impedance (electric resistance) of such a capacitor and the noise frequency; and
Fig. 9 is an example of an MIS capacitor arrangement on an integrated circuit.

A detailed explanation of the preferred embodiments with reference to the drawings is given below.

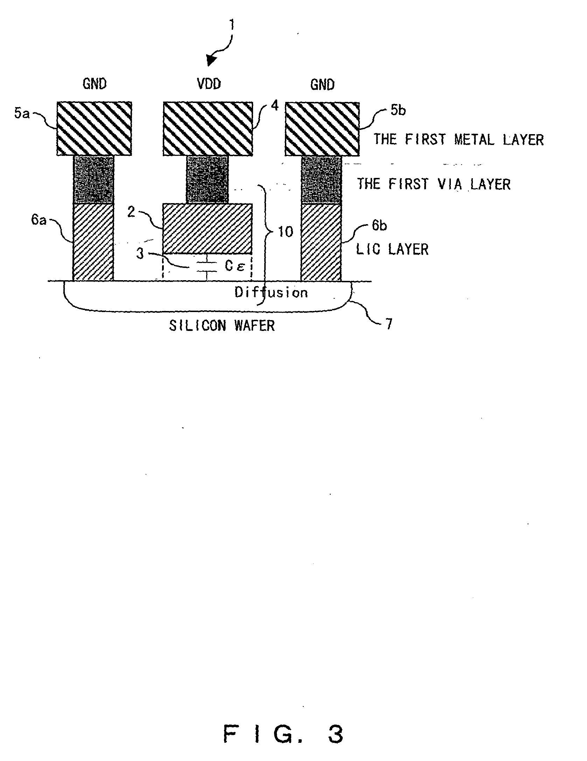

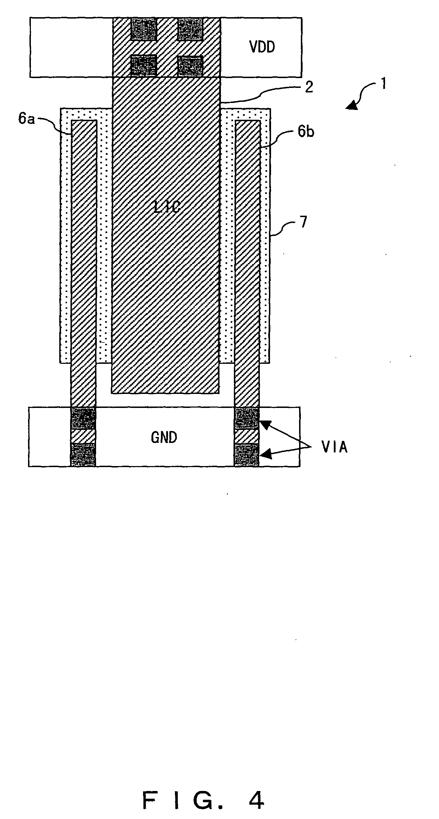

Fig. 3 is a cross-sectional diagram of an embodiment of an MIS (Metal-Insulator-Silicon) capacitor. Fig. 4 represents an overhead view of the MIS (Metal-Insulator-Silicon) capacitor of Fig. 3. There is a Local Interconnect (LIC) layer 2 constructed with material such as tungsten, and LIC layers 6a and 6b directly joined on to (formed over) the silicon wafer 8. LIC layer 2 is joined onto the silicon wafer 8 through an oxide film such as field oxide film 3. Wiring layer 4, which is connected to power supply wiring VDD, is set up(deposited) on a first via layer, which is mounted on LIC layer 2. Wiring layers 5a and 5b, each connected to power supply wiring GND, are set up on first via layers, which are mounted on LIC layer 6a and 6b respectively. Diffusion area 7 is formed on the surface of the silicon wafer 8, joined to field oxide film 3, which is between the LIC layer 2 and the silicon wafer 8, LIC layer 6a and LIC layer 6b.

In this example, field oxide film with a dielectric constant of ε is used as an example of an oxide film serving as capacitance film that is located between the silicon wafer 8 and the LIC layer 2 and that is connected to VDD 4 through the first via layer. The field oxide film 3 makes up a capacitor unit 10, together with the LIC layer 2 that comprises the upper electrode and the silicon wafer that comprises the lower electrode. The dielectric constant ε of the field oxide film 3 can be greater than the dielectric constant ε1 of gate oxide.

LIC layer 2 that is connected to power supply wiring VDD and which comprises the upper electrode of the capacitor unit 10 is composed of an electrically conductive metal. As a result, the diffusion area is formed in the area (region) where silicon wafer 8 contacts with field oxide film 3.

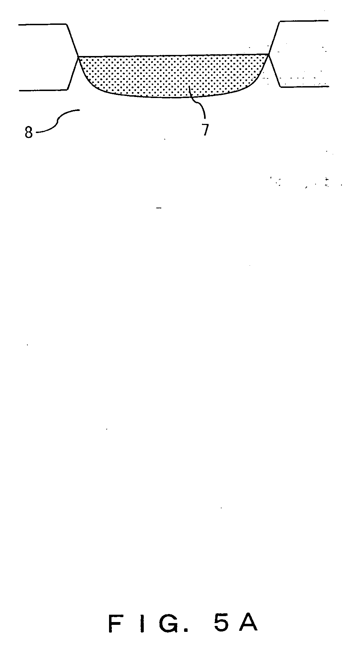

Fig. 5A to Fig. 5E show the production process for the embodiment of the MIS (Metal-Insulator-Silicon) capacitor. The detailed explanation of the production process of MIS capacitor 1 with reference to the drawings is given below.

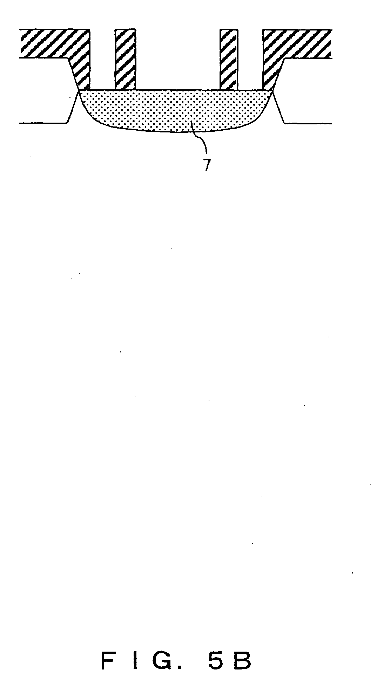

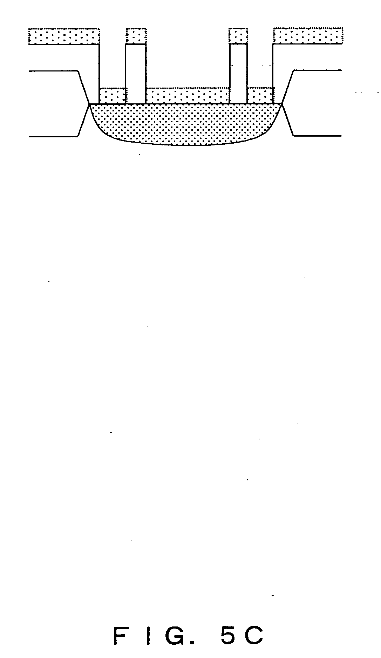

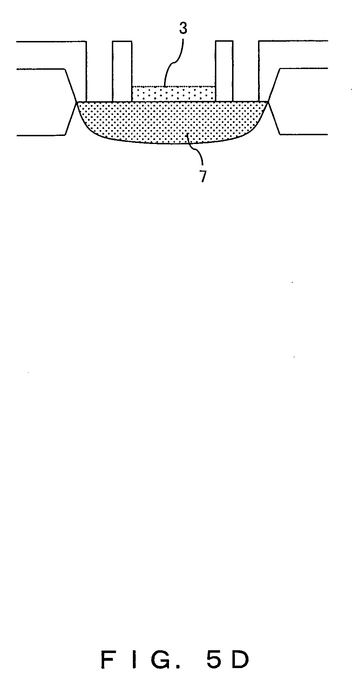

First, as shown in Fig. 5A, diffusion area 7 is formed on the silicon wafer 8. Compared with the diffusion area formed on the conventional capacitor indicated in Fig. 1, the present embodiment of MIS capacitor 1 has the diffusion area 7 formed in the region underneath the capacitor unit 10. Next, an insulator layer is formed over the whole surface of the silicon wafer 8 including over diffusion area 7, and then holes are made in the insulator layer at points where wiring metals and an electrode are to be formed. Fig. 5B shows the holes made at the points where wiring metals and the electrode are formed in the insulator layer. The insulator, in which the holes are made, is represented by the areas with diagonal lines in Fig. 5B. After making the holes, as shown in Fig. 5C, oxide film is formed on the surface of the insulator and diffusion area. The oxide film is removed by etching except for at the region where the upper electrode is to be formed, as is shown in Fig. 5D.

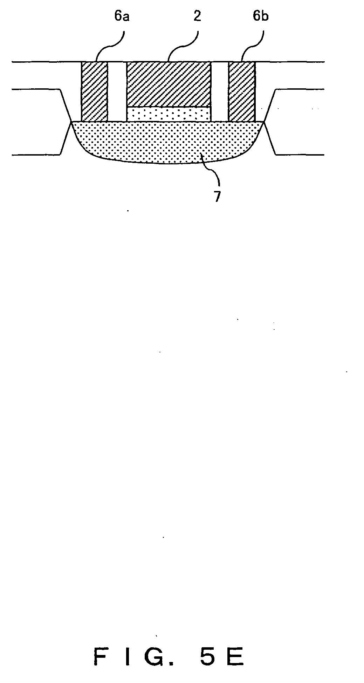

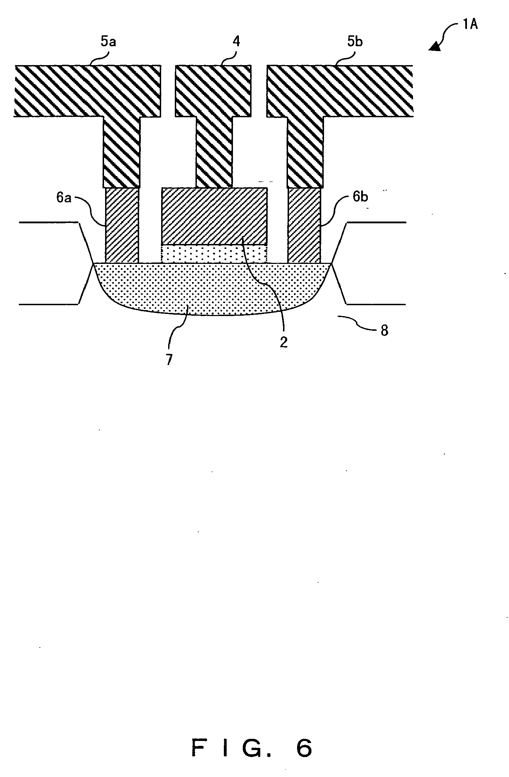

Fig. 5E is a diagram showing the electrode and second metal layer formed with metal as a LIC layer. The LIC layer is formed by filling the holes in the insulator layer with metal, and the metal is brought into contact with the diffusion area of the silicon wafer. Lastly, providing metal for wiring (wiring layer) completes the whole production process of the MIS capacitor 1 shown in Fig. 3. In Fig. 3, via layers are formed between LIC layer 2, 6a and 6b and wiring layer 4, 5a and 5b respectively, but the embodiment is not limited to this particular construction. As another example of the embodiment of an MIS (Metal-Insulator-Silicon) capacitor, for example, the via layer can be an embedded via layer with stack architecture and wiring placed directly to this part. Fig. 6 is a cross-sectional diagram of such an MIS capacitor 1.

According to the above-described production method of an MIS capacitor, dielectric is formed in predetermined thickness with a predetermined dielectric constant as oxide film between the electrodes. And this method can give the desired capacitance to capacitor unit 10. By utilizing this result, the leakage current, which is peculiar (inherent) to transistors, can be reduced to a trivial level. Generally, the following relationship is established between leakage current Ig at the gate and thickness of gate oxide $T_{ox}$.

$$I_g \propto 1/T_{ox}$$

As the formula above indicates, the value of the leakage current is inversely proportional to the thickness of the oxide film of capacitor unit 10. To be more specific, making the thickness of the gate oxide 20Å thicker can eliminate one significant figure from the value of the leakage current Ig. In the present embodiment of an MIS (Metal-Insulator-Silicon) capacitor, a field oxide film is used for capacitor unit 10 instead of using a gate oxide film, which is used in conventional transistors. This field oxide film can be manipulated to have predetermined thickness and dielectric constant. In the case that a dielectric (oxide film) with dielectric constant $\varepsilon$ is used, the relationship between the thickness of the oxide film (distance between electrodes) T and capacitance of the capacitor unit 10 with electrode area S is expressed as follows:

$$C = \varepsilon * S/T \quad (1)$$

In the present embodiment of an MIS (Metal-Insulator-Silicon) capacitor, the dielectric constant $\varepsilon$ and thickness T can be set freely even though the electrode area S remains the same. By utilizing this, the leakage current can be reduced. This reduction of the leakage current keeps the power consumption of capacitor 10 under control.

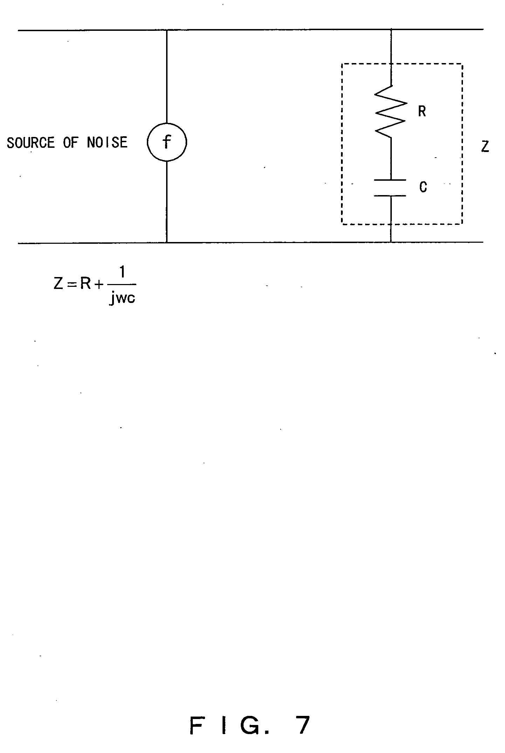

Fig. 7 explains the specific characteristics of a capacitor 10 based on the structure of the above embodiment of an MIS capacitor. Assume that frequency of the noise source is f, capacitance of the capacitor unit 10 is C, regarding the LIC layer comprising the upper electrode of capacitor unit 10, sheet resistance is R, and impedance of capacitor unit 10 is Z. Additionally, capacitance C is generated in the area where the LIC layer 2 and the diffusion area overlap each other in Fig. 3 and Fig.4.

The impedance Z in Fig.7 is expressed as the following.

$$Z=R+1/j\omega c \quad (2)$$

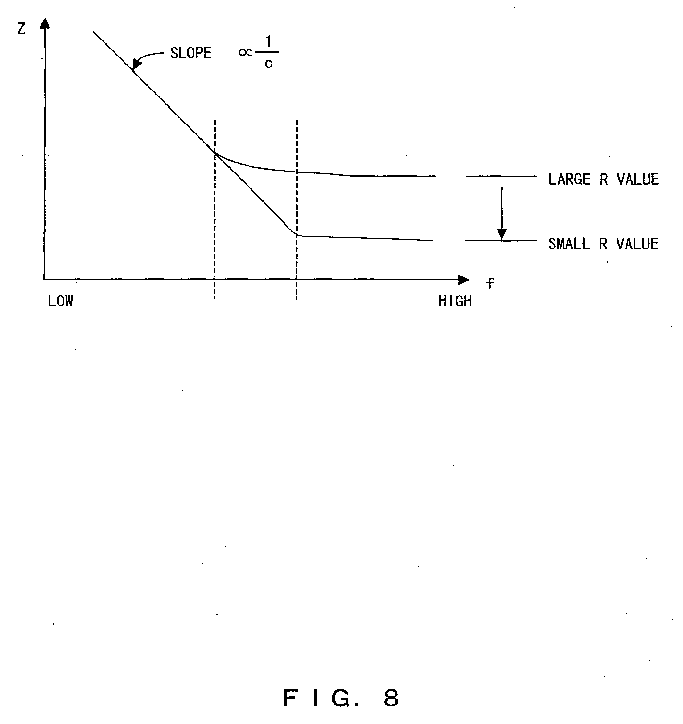

In the above expression, j represents the imaginary number. Fig. 8 is a graph in approximation showing the relation, represented by the expression (2), between absolute value of impedance Z and noise frequency f in the capacitor. In the area of high frequency of noise, that is the area with large f value, the absolute value of impedance Z is mainly affected by the resistance R rather than by capacitance of the capacitor unit 10.

Here, assume $R=0.3[\Omega/\square]$ for the sheet resistance R of the present embodiment of capacitor unit 10. On the other hand, assume $Rp=10[\Omega/\square]$ for the sheet resistance Rp in the polygate layer of the present embodiment of capacitor unit 10. That is to say, compared with a capacitor utilizing polygate in a transistor as in the conventional manner, resistance at the upper electrode of the present embodiment of a capacitor is 0.3/10=0.03 times lower, i.e. is lowered by a factor of thirty. By reducing the upper electrode resistance by a factor of thirty, the influence of the sheet resistance R in the high frequency range becomes small, even though the capacitance C of the capacitor unit 10 is affected mainly by high frequency noise. In other words, reduction of the sheet resistance can make the capacitor function more effectively in the high-frequency range without changing the capacitance of the capacitor because of the noise.

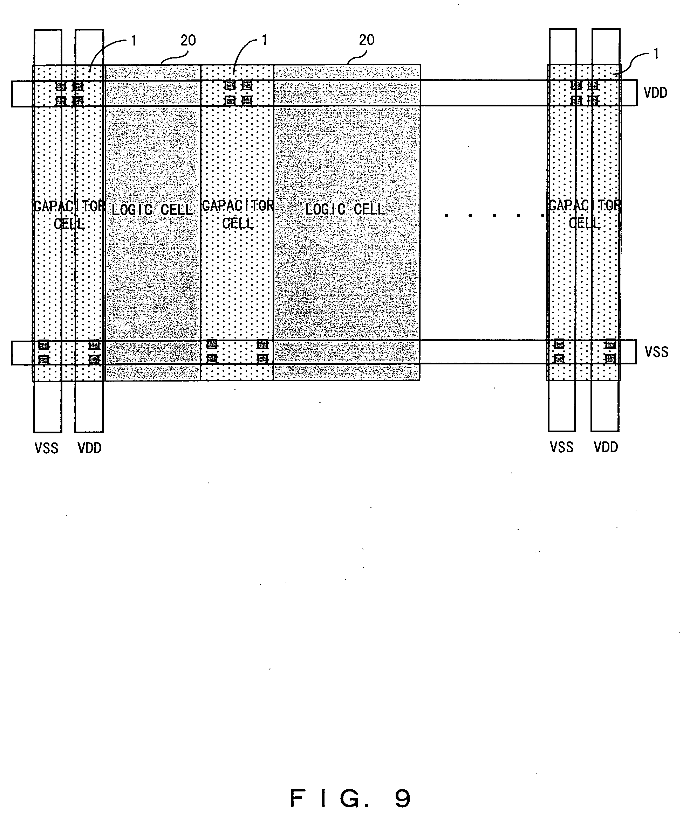

Fig.9 is an example configuration of the present embodiment of an MIS capacitor arranged on an integrated circuit. In Fig. 9, capacitor cells 1 and logic cells 20 are arranged on the integrated circuit 30, according to the design. Each logic cell 20 is arranged following the logic connection information of the integrated circuit. VDD wirings and VSS (GND) wirings arranged horizontally in the diagram are power supply wiring for the first layer, and VDD wiring and VSS (GND) wiring arranged vertically in the diagram are power supply wiring for the second layer in Fig. 9. The present embodiment of capacitor cell 1 is arranged on the integrated circuit in order to control the voltage variation caused by crosstalk noise between wirings and simultaneous switching etc.

Incidentally, in regard to the present embodiment of MIS capacitor, that is capacitor cell 1 in Fig. 9, as is clear from expression (1), its capacitance is determined by the dielectric constant $\varepsilon$ of the dielectric using field oxide film and by the thickness of the oxide film T, and there is no need to change the electrode area S. That is, compared with the conventional design, no change in space for the present embodiment of MIS capacitor is needed, and therefore, capacitor cell 1 can be introduced without changing the design of the conventional integrated circuit.

As explained above, in the present embodiment of an MIS capacitor, because the upper electrode is composed of metal, the sheet resistance in the upper electrode of the capacitor can be lowered. As a result, an increase of capacitance in the high frequency area becomes possible. Also, because dielectric is used as an oxide film in the MIS capacitor and thickness of the oxide film can be set freely, the capacitance of the MIS capacitor can be set flexibly. And using oxide film material with higher dielectric constant allows the capacitor to maintain a large capacitance, reduces leakage current in the capacitor and controls the power consumption of the integrated circuit. In addition, because there is no need to change the area of the upper electrode of the MIS capacitor, more effective control of high frequency noise is possible without changing the area of the silicon wafer occupied by the capacitor.

Hence, an improved MIS capacitor based on a transistor is provided.

**Claims**

1. A MIS capacitor (1) comprising:

   a silicon wafer (8) having a diffusion area (7) formed in a predetermined region on one side and that comprises a lower electrode of a capacitor unit (10);
   a first metal layer (2) that is connected to a first power supply wiring and that comprises an upper electrode of the capacitor unit (10);
   a second metal layer (6a, 6b) connected to a second power supply wiring and formed on the surface of the diffusion area (7) of the silicon wafer (8); and
   an oxide film (3) placed between the first metal layer (2) and the surface of the diffusion area (7) on the silicon wafer (8).

2. The MIS capacitor (1) according to claim 1, wherein
   the first metal layer (2) is connected to the first power supply wiring through a first wiring metal which is electrically conductive; and
   the second metal layer (6a, 6b) is connected to the second power supply wiring through a second wiring metal which is electrically conductive.

3. The MIS capacitor (1) according to claim 1 or 2, wherein
   the first power supply wiring is connected to a gate, formed by said oxide film, of a transistor constituting the MIS capacitor (1), and the second power supply wiring is connected to either a source or a drain of the transistor.

4. The MIS capacitor (1) according to any preceding claim, wherein
   each of the first and second metal layers (2, 6a, 6b) is local interconnect.

5. The MIS capacitor (1) according to any preceding claim, wherein
   each of the first and second metal layers (2, 6a, 6b) is composed of tungsten.

6. The MIS capacitor (1) according to any preceding claim, wherein
   the oxide film is a field oxide film.

7. The MIS capacitor (1) according to any preceding claim, wherein
   said MIS capacitor (1) is used as a noise-reducing capacitor cell in an integrated circuit.

8. An MIS capacitor production method, comprising steps of:

   forming a diffusion area on a predetermined region of a silicon wafer;
   forming an insulator layer on the silicon wafer;
   making a first hole, a second hole, and a third hole in the insulator layer, each of the holes reaching the diffusion area on the silicon wafer through the insulator layer;
   forming an oxide film with a predetermined thickness at the bottom of the first hole; and
   filling the first hole, the second hole, and the third hole with metal.

9. An integrated circuit chip comprising an MIS capacitor according to any of claims 1 to 7.

Prior Art

50

GND                    VDD                    GND

55a                                54          55b
                                                    THE FIRST METAL LAYER

                                                    THE FIRST VIA LAYER

56a         51                          59          56b
                                                    LIC LAYER
            53          $C_1 \varepsilon_1$

Diffusion              Diffusion

57a              58 SILICON WAFER              57b

# F I G. 1

Prior Art

F I G. 2

1

GND                VDD                GND

5a                          4              5b

THE FIRST METAL LAYER

THE FIRST VIA LAYER

6a        2                    10        6b

3          C ε          LIC LAYER

Diffusion

SILICON WAFER        7

FIG. 3

F I G. 4

F I G. 5 A

7

F I G. 5 B

F I G. 5 C

F I G. 5 D

F I G. 5 E

F I G. 6

SOURCE OF NOISE $\quad$ (f) $\qquad\qquad$ R $\qquad$ Z

C

$$Z = R + \frac{1}{jwc}$$

# F I G. 7

F I G. 8

F I G. 9